# FASCICULE DE BREVET EUROPEEN

(11) **EP 1 829 105 B1**
(45) Date de publication et mention de la délivrance du brevet: **16.02.2011**
(21) Numéro de dépôt: 05815910.4
(22) Date de dépôt: 07.12.2005
(51) Int. Cl.: H01L 23/04

(54) **BOITIER MINIATURE HYPERFREQUENCE ET PROCEDE DE FABRICATION DU BOITIER**
MIKROWELLEN-MINIATURGEHÄUSE UND VERFAHREN ZUR HERSTELLUNG DIESES GEHÄUSES
MICROWAVE MINIATURE CASING AND METHOD FOR PRODUCING THIS CASING

(30) Priorité: 20.12.2004 FR 0413584
(43) Date de publication de la demande: 05.09.2007
(73) Titulaire: United Monolithic Semiconductor S.A.S., 91401 Orsay Cedex (FR)
(72) Inventeur: BESSEMOULIN, Alexandre, F-92320 CHATILLON (FR)
(74) Mandataire: Lucas, Laurent Jacques
(86) Numéro de dépôt international: PCT/EP2005/056583
(87) Numéro de publication internationale: WO 2006/067045

(56) Documents cités:
- US-A- 5 694 300
- US-A1- 2004 159 920
- US-A1- 2004 171 186
- PATENT ABSTRACTS OF JAPAN vol. 009, no. 136 (E-320), 12 juin 1985 (1985-06-12) & JP 60 020538 A (HITACHI SEISAKUSHO KK), 1 février 1985 (1985-02-01)

## Description

L'invention concerne un boîtier miniature pour l'encapsulation de circuits intégrés hyperfréquences fonctionnant jusqu'à des fréquences de 200GHz et notamment la protection du circuit intégré encapsulé dans le boîtier.

L'évolution des applications en hyperfréquences à des fréquences de plus en plus élevées entraîne une demande croissante de circuits intégrés présentant une grande intégration et compacité.

Les boîtiers hyperfréquences de l'état de l'art utilisent notamment des technologies organiques (PCB) ou céramique. Le principe commun de ces boîtiers consiste à reporter une puce électronique dans un boîtier et de l'interconnecter principalement par des fils conducteurs, pour les circuits comportant des lignes de type microruban, ou plus rarement par des plots de soudure (ou bumps en langue anglaise) pour les circuits uniplanaires. Le circuit intégré est protégé contre les agressions physiques, chimiques ou autres provenant du milieu extérieur notamment par la fermeture du boîtier par un capot.

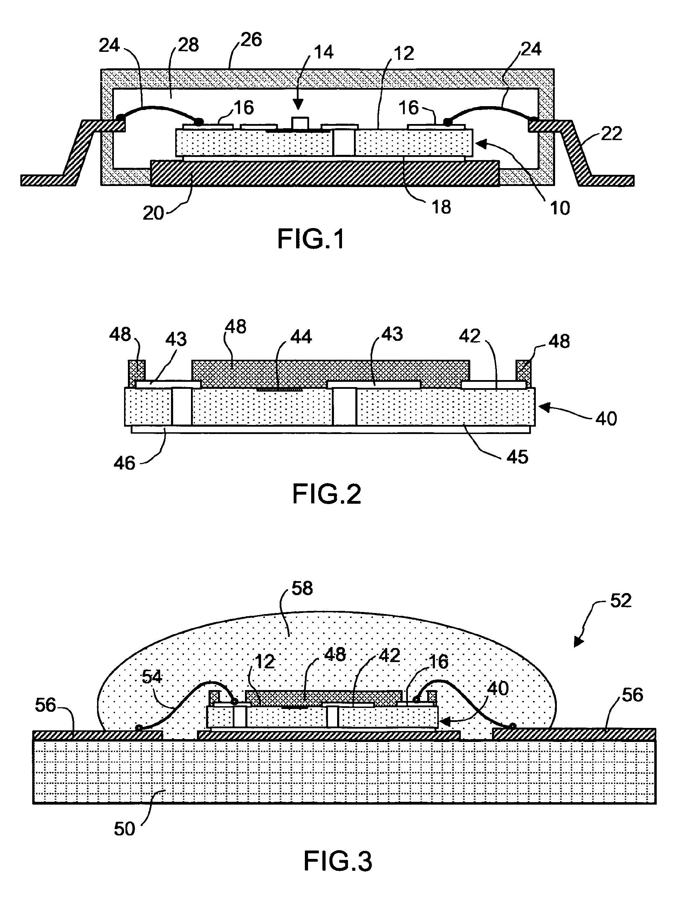

La figure 1 représente un exemple de réalisation d'un boîtier hyperfréquence de l'état de l'art couramment désigné par MMIC soit en langue anglaise « Monolithic Microwave Integrated Circuit » fonctionnant dans des gammes de fréquences comprises entre 1 GHz et 100Ghz.

Le boîtier hyperfréquence de la figure 1 comporte essentiellement une puce hyperfréquence 10 ayant une face active 12 intégrant des composants hyperfréquences actifs 14 notamment des transistors, des conducteurs électriques 16 et une face arrière 18 opposée à la face active. La puce 10 est reportée par sa face arrière 18 sur un fond métallique 20 du boîtier hyperfréquences. Le boîtier comporte des plots électriques sous forme de pattes métalliques 22 pour son report sur un circuit d'interconnexion (ou circuit d'accueil), non représenté sur la figure.

Les pattes métalliques 22 du boîtier de la figure 1, solidaires mécaniquement du boîtier, assurent les liaisons électriques entre la puce 10 et le milieu extérieur au boîtier par l'intermédiaire de fils électriques 24 reliant les conducteurs électriques 16 de la face active de la puce aux pattes métalliques 22 du boîtier.

Le boîtier de la figure 1 est fermé par un couvercie 26 protégeant la puce du milieu extérieur. La puce se trouve alors dans une cavité d'air 28 (ou un gaz) formée par le boîtier fermé par son couvercle

Le boîtier hyperfréquence de la figure 1 est destiné à être reporté sur une carte électronique pour l'interconnexion, par exemple, avec d'autres circuits électroniques.

La demande de brevet US 2003/0111714 A1 montre un boitier en céramique pour le montage d'un circuit intégré millimétrique. Le circuit intégré est déposé dans une cavité du boîtier fermé par un capot.

Les figures 2 et 3 montrent deux autres techniques de l'état de l'art de protection des circuits intégrés.

La figure 2 représente une puce hyperfréquence 40 ayant une face active 42 comportant des conducteurs électriques 43 de la face active, la face active intégrant des composants hyperfréquences actifs 44 et une face arrière 45 opposée à la face active comportant des conducteurs électriques 46 de la face arrière.

La protection du circuit intégré 40 est effectuée par le dépôt d'une couche diélectrique de protection 48 de quelques micromètres sur la face active 42 de la puce (technologie BCB, benzo-cyclo-butène) protégeant ainsi les éléments fragiles du circuit intégré comme les transistors ou les ponts à air.

Dans la figure 3 le circuit intégré 40 comportant la couche diélectrique de protection 48 sur la face active 42 est reporté sur un substrat 50 d'un boîtier hyperfréquences 52. Les conducteurs électriques 16 de la face active 12 de la puce sont reliés électriquement par des fils 54 à des connecteurs électriques 56 du boîtier.

Une fois la puce 40 reportée et assemblée sur le substrat 50, le boîtier 52 est fermé par déposition d'une couche (ou goutte) 58 de matériau diélectrique (technologie glob-top) sur la totalité du circuit intégré 40 le protégeant du milieu extérieur.

Le brevet US 6,472, 748 B1 montre des réalisations de boîtiers pour l'encapsulation d'une puce hyperfréquence (MMIC). Les boîtiers sont fermés, soit par un capot, soit par un enrobage d'une partie du boîtier comportant la puce.

Ces différentes solutions de l'état de l'art pour la protection des circuits intégrés des boîtiers hyperfréquences comportent des inconvénients notamment :
- l'encombrement des boîtiers existants (de l'ordre de 20 mm²) ;
- la réduction des performances électriques, en particulier dans les applications logiques et analogiques rapides, notamment en hyperfréquence, due à la longueur des interconnexions (fils de câblage, ou bonding wires, lignes de transitions, etc.), et aux éléments parasites liés aux dimensions des boîtiers de l'art antérieur. En particulier, l'inductance parasite résuitante de ces mises en boîtier limitant le gain, la stabilité et la fréquence d'utilisation du circuit encapsulé ;

- l'incompatibilité de certaines solutions de boîtiers de l'art antérieur avec les techniques de montage en surface ;
- la nécessité d'équipements de production pour le test des composants en boîtiers (test fixture, handler, etc.) ;

En outre, les principaux inconvénients des solutions à base de protection diélectriques sont :
- la réduction sensible des performances, en particulier pour les applications hyperfréquence, due à l'emploi du diélectrique, ayant pour effet d'augmenter les capacités parasites dans les composants actifs (transistors) et passifs ;
- la réduction des performances électriques, en particulier dans les applications logiques et analogiques rapides, due à la longueur des fils de câblage.

Afin de pallier les inconvénients des boîtiers hyperfréquences de l'état de l'art, l'invention propose un boîtier miniature hyperfréquences comportant une puce hyperfréquence ayant une face active, comportant des conducteurs électriques de la face active, des composants hyperfréquences actifs, une face arrière opposée à la face active comportant des conducteurs électriques de la face arrière, un capot de protection. Le capot de protection est fixé sur la face active de la puce la recouvrant au moins partiellement, le capot de protection ayant au moins un évidement formant une cavité avec la face active de la puce.

Dans une réalisation préférentielle du boîtier selon l'invention, le capot de protection recouvre la totalité de la face active de la puce.

Dans d'autres réalisations du boîtier selon l'invention, le capot de protection comporte plusieurs évidements, chacun des évidements formant une cavité avec la face active de la puce.

Un principal objet de l'invention est de proposer un boîtier hyperfréquences miniature de faible coût ayant des très bonnes performances et fonctionnant jusqu'à des fréquences de 200 GHz.

Un autre objet de cette invention est de proposer un boîtier hyperfréquences miniature compatible avec les technologies de montage en surface (SMD soit surface mount devices en langue anglaise).

D'autres objectifs de cette invention sont de proposer une protection complète de la face active du circuit intégré encapsulé dans son boîtier, le rendant plus robuste et plus facile à manipuler.

L'invention concerne aussi un procédé de fabrication des boîtiers en collectif diminuant le coût de fabrication des boîtiers.

L'invention sera mieux comprise à l'aide d'exemples de réalisations de boîtiers miniatures hyperfréquence en référence aux figures ci-annexées dans lesquelles :
- la figure 1, déjà décrite, représente un exemple de réalisation d'un boîtier hyperfréquence de l'état de l'art ;
- les figures 2 et 3, déjà décrites, montrent deux autres techniques de protection des circuits intégrés de l'état de l'art ;
- la figure 4 montre un boîtier hyperfréquences selon l'invention ;
- la figure 5 représente une première variante du boîtier de la figure 4 ;
- la figure 6 représente une deuxième variante du boîtier de la figure 4 ;
- la figure 7 représente une vue partielle d'une troisième variante du boîtier de la figure 4 ;
- la figure 8 représente une autre réalisation du boîtier hyperfréquences selon l'invention ;
- la figure 9 montre une autre réalisation d'un boîtier hyperfréquences, selon l'invention, comportant un capot de protection de surface inférieure à celle de la face active de la puce.
- les figures 10a, 10b, 10c, 10d et 10e montrent les principales étapes d'un premier procédé de fabrication en collectif de boîtiers selon l'invention ;
- les figures 11a, 11b, 11 c, 11 d et 11 e montrent un procédé d'encapsulation d'un circuit intégré protégé par un capot selon l'invention.

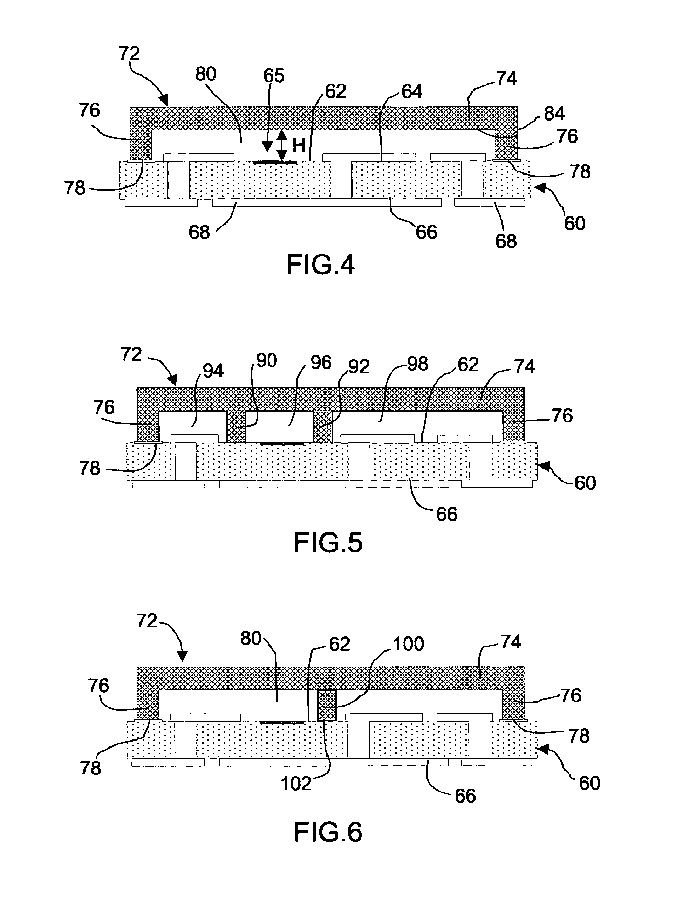

La figure 4 montre un boîtier hyperfréquences selon l'invention comportant une puce (ou circuit intégré) hyperfréquence 60 ayant une face active 62 comportant des conducteurs électriques 64 de la face active, la face active intégrant des composants hyperfréquences actifs 65 et une face arrière 66 opposée à la face active comportant des conducteurs électriques 68 de la face arrière pour le report du circuit intégré sur un substrat d'accueil (non représenté sur la figure) pour l'interconnexion, par exemple, avec d'autres circuits intégrés ou l'encapsulation dans un boîtier moulé.

Le circuit intégré 60 comporte un capot 72 de protection ayant une plaque supérieure 74 parallèle à la face active 62 de la puce. La plaque supérieure 74 est prolongée par des parois 76 perpendiculaires à la plaque suprérieure se terminant par des bords 78 en contact avec la face active 62 de la puce de façon à former avec la puce une cavité 80 comprise entre la plaque supérieure 74 du capot de protection et la face active.

Le capot 72 de protection est reporté sur la puce par des méthodes connues recouvrant la totalité de sa face active 62.

Le capot 72 de protection, de surface proche ou inférieure à celle du circuit intégré 60 et de très faible épaisseur est réalisée de préférence dans un matériau choisi parmi, le silicium, plastique, diamant, verre, matériau organique ou polymère, métal.

La figure 5 représente une première variante du boîtier de la figure 4. Dans cette première variante, le capot 72 comporte d'autres parois 90, 92 perpendiculaires à la plaque supérieure 74 du capot de protection de façon à former plusieurs autres cavités 94, 96, 98 avec la face active 62 de la puce.

L'avantage d'un capot de protection formant avec la face active de la puce plusieurs cavités est de pouvoir effectuer des isolements électromagnétiques entre certaines zones de la face active de puce ou entre certaines zones de la face active de la puce et le milieu extérieur. La fermeture du boîtier par le capot de protection effectue ces isolements sans aucune autre opération de fabrication simplifiant ainsi la fabrication du boîtier.

Des évidements dans le capot de protection, du coté de la face active de la puce, formant les cavités 80, 94, 96, 98 avec la dite face active peuvent être réalisés soit par gravure, soit par moulage. Le capot de protection, en contact avec la face active de la puce par les bords des évidements de la plaque forment les cavités entre le capot et la face active.

La figure 6 représente une deuxième variante du boîtier de la figure 4. Dans cette deuxième variante, le capot 72 comporte des piliers 100 distribués sous la plaque supérieure 74 du capot en contact avec la face active 62 de la puce par son bord 102. Ces piliers sont destinés à soutenir ledit capot 72 sur le circuit intégré. A cet effet les piliers ont la même hauteur H que les parois 76 du capot de protection de façon à ce que les parois 76 et les piliers 100 soient en contact par leurs bords respectifs 78, 102 avec la face active de la puce.

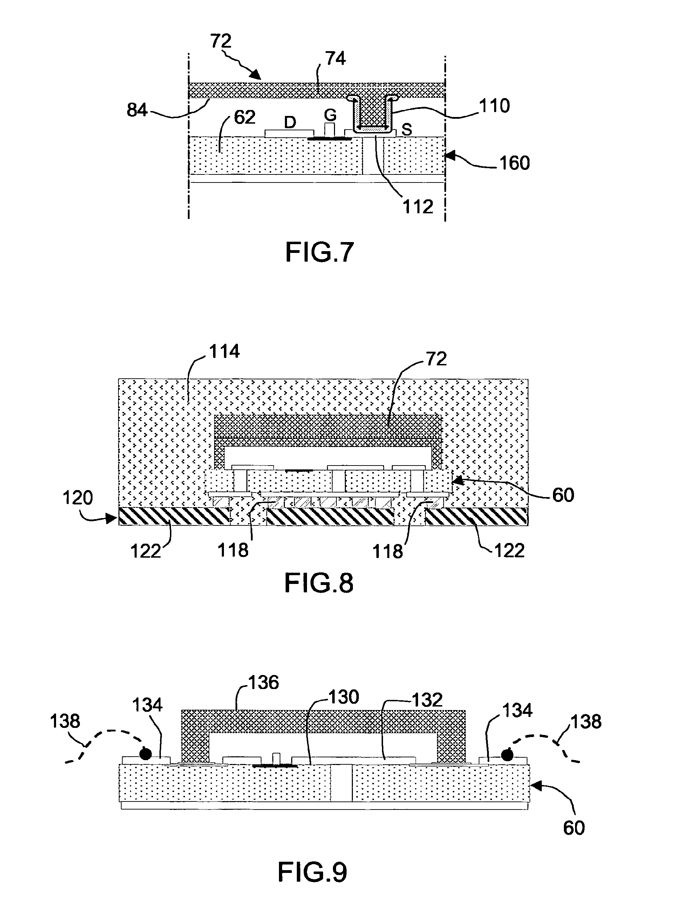

La figure 7 représente une vue partielle d'une troisième variante du boîtier de la figure 4. Dans cette troisième variante, le capot de protection comporte, du coté de la face 84 de la plaque 72, faisant face à la face active 62 de la puce, des conducteurs électriques et thermiques 110 du capot en contact avec des conducteurs électriques de la face active 112 de la puce.

Dans la réalisation de la figure 7 le conducteur électrique de la face active 112 est la source S d'un transistor à effet de champ de la face active de la puce. La source S est reliée à la masse du capot 72 assurant l'évacuation des calories dégagées par le transistor.

De façon générale, les conducteurs électriques et thermiques 110 du capot de protection assurent d'une part, une liaison électrique avec des conducteurs électriques de la puce (par exemple des conducteurs de masse) et d'autre part l'évacuation vers le capot de la chaleur dégagée par la puce.

Dans des exemples de réalisations pratiques du capot, la profondeur H des évidements dans le capot, ou la profondeur des cavités dans le circuit intégré protégé, est comprise entre 10 et 500 micromètres.

Pour certaines applications des puces en hyperfréquences, les cavités formées par le capot avec le circuit intégré sont utilisées pour la réalisation de guides d'ondes ou filtres hyperfréquences.

Dans une autre réalisation d'un boîtier hyperfréquences selon l'invention, représenté à la figure 8, le circuit intégré 60 comportant le capot 72 de protection est reporté par des plots électriques 118 (par exemple des plots de soudure) sur un fond de boîtier 120 comportant un réseau de connecteurs électriques 122 ou « leadframe » en langue anglaise, pour le report du boîtier sur un circuit d'accueil ayant une résolution de conducteurs électriques inférieure à celle du circuit intégré 60.

Le boîtier de la figure 8 est fermé par un moulage 114 englobant la puce 60 avec son capot 72 de protection laissant apparaître les plots électriques 112 pour l'interconnexion du boîtier sur un circuit d'accueil.

La figure 9 montre une autre réalisation d'un boîtier hyperfréquences, selon l'invention, comportant un capot de protection de surface inférieure à celle de la face active de la puce.

Le boîtier de la figure 9 comporte le circuit intégré 60 ayant une face active 130 comportant des conducteurs électriques 132 de la face active et parmi ces conducteurs de la face active des connexions électriques 134 pour la liaison électrique de la puce avec un circuit extérieur.

La puce est protégée par un capot 136 de protection solitaire de la face active 130 de la puce, de même structure que le capot du boîtier de la figure 4, mais ayant une surface plus petite que la surface de la face active de la puce la recouvrant partiellement à fin de laisser apparaître les connexions électriques 134 de la puce.

La puce 60 peut être reportée sur un substrat d'accueil (non représenté sur la figure) comportant des plots électriques. Les plots électriques du substrat sont alors reliés par des fils d'interconnexion 138 (en pointillé) aux connexions électriques 134 de la puce.

L'invention concerne aussi un procédé de fabrication en collectif de boîtiers miniature hyperfréquences selon l'invention.

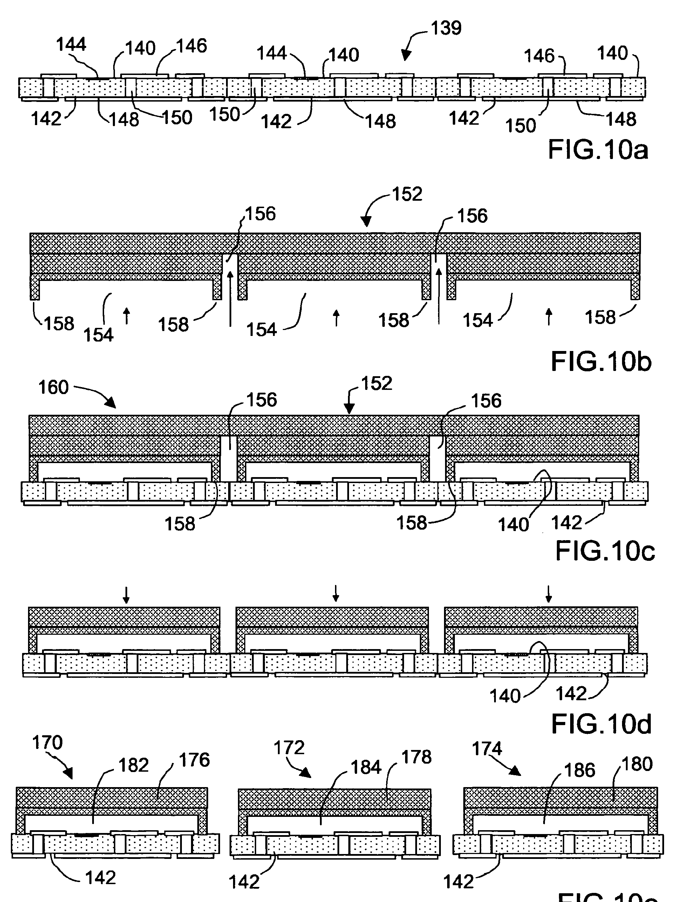

Les figures 10a, 10b, 10c, 10d, 10e montrent les principales étapes d'un premier procédé de fabrication en collectif de boîtiers miniature hyperfréquence comportant un circuit intégré protégé par un capot, selon l'invention :

Le premier procédé de fabrication en collectif du boîtier selon l'invention comporte au moins les étapes suivantes :
- fabrication, par exemple, sur une galette, soit d'Arséniure de Gallium, soit de Nitrure de Gallium, ou soit de Phosphore d'Indium, monocristallin, ou « wafer » en langue anglaise, d'un ensemble de circuits intégrés 139 (voir figure 10a). Chacun des circuits intégrés comporte une face active 140 et une face arrière 142 opposée à la face active, la face active comportant des éléments actifs 144, des conducteurs électriques 146 de la face active, la face arrière 142 comportant des conducteurs électriques 148 de la face arrière. Des trous métallisés 150 dans la puce relient les conducteurs électriques 146 de la face active aux conducteurs électriques 148 de la face arrière ;
- fabrication d'un « wafer » capot 152 à partir d'une galette de Silicium avec gravure (voir figure 10b) :
   a) des évidements 154 destinés à la réalisation des cavités avec les faces actives des puces à protéger ;
   b) des chemins de découpe 156 entre les capots pour la séparation des circuits intégrés capotés ;
- dépôt localisé d'un élément adhésif sur les bords 158 des évidements154 ;
- report du « wafer » capot 152 par les bords 158 des évidements 154 sur le « wafer » circuits intégrés (de la figure 10a) sur les faces actives 140 des circuits intégrés par collage ou par « wafer » bonding constituant un « wafer » circuits intégrés encapsulés 160 (voir figure 10c) ;
- amincissement du « wafer circuits intégrés encapsulés 160 par le coté du « wafer » capot 152 jusqu'aux chemins de découpe 156 séparant les capots de protection des circuits intégrés du « wafer circuits intégrés (voir figure 10d) ;
- découpe du « wafer » circuits intégrés encapsulés 160 pour séparer les boîtiers 170, 172, 174 selon l'invention comportant les circuits intégrés protégés par leurs respectifs capots 176, 178, 180 (voir figure 10e).

Les évidements 154 des capots forment avec leurs respectives faces actives des cavités 182, 184, 186.

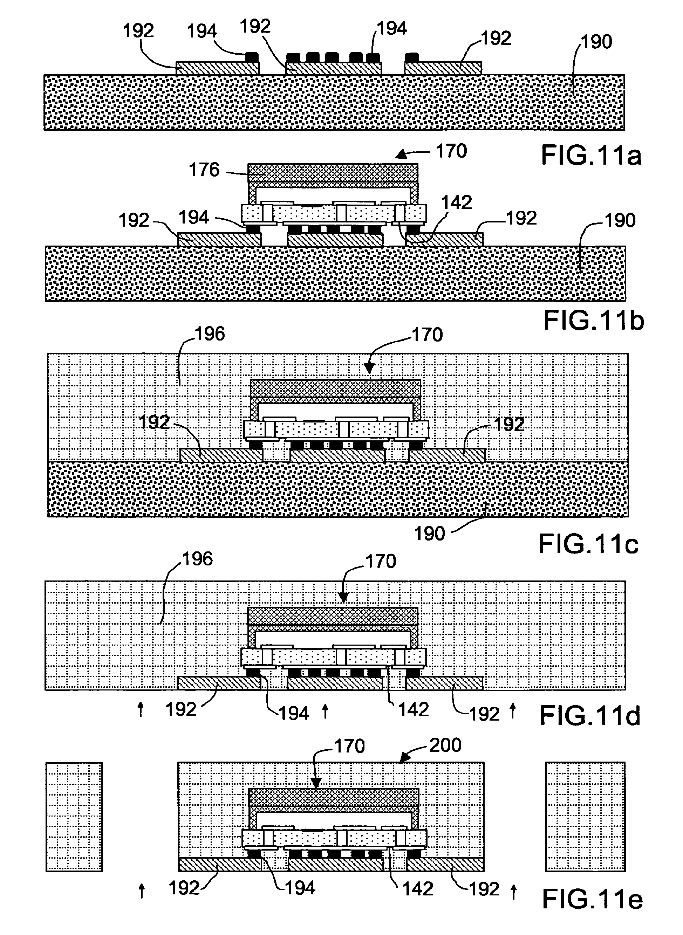

Les figures 11a, 11 b, 11 c, 11 d et 11 e montrent un procédé d'encapsulation d'un boîtier selon l'invention comportant un circuit intégré protégé par un capot obtenu par exemple selon le procédé de fabrication en collectif décrit précédemment aux figures 10a à 10e.

Le procédé d'encapsulation représenté aux figures 11a à 11e, comporte au moins les étapes suivantes :
- croissance sur un substrat temporaire 190 d'un réseau de plots électriques 192 ou « leadframe » et des plots de soudure 194 sur les plots électriques 192 (voir figure 11 a) ;
- report du boîtier 170 comportant un circuit intégré protégé par son capot 176 par sa face arrière 142 sur le réseau de plots électriques 192 par l'intermédiaire des plots de soudure 194 (voir figure 11 b) ;
- moulage 196 du circuit intégré protégé par son capot et du réseau de plots électriques 192 sur le substrat temporaire190 (voir figure 11c) ;
- amincissement du substrat temporaire 190 jusqu'aux plots électriques 192 du « leadframe » (voir figure 11 d) ;
- découpe et séparation d'un boîtier moulé 200 comportant le circuit intégré protégé par son capot (voir figure 11 e).

On peut décliner le concept général de l'invention en plusieurs solutions suivant le substrat utilisé et certaines modifications apportées sur le circuit intégré :

Pour obtenir un blindage : par l'utilisation d'un boîtier de l'art antérieur (à patte ou de type QFN) pour l'encapsulation globale du composant.

Pour augmenter la compacité : utilisation d'une protection de type Glob-top sur le circuit intégré protégé.

Pour améliorer l'herméticité : par l'utilisation d'un substrat et un capot en céramique.

Pour augmenter la puissance : par l'utilisation d'un substrat à haute conductivité thermique choisi parmi le diamant, AIN, BeO..., ou d'un substrat bas coût standard (PCB, LTCC, HTCC..) avec vias thermiques. On peut combiner cette solution d'encapsulation avec des circuits intégrés MMIC optimisées en thermique par l'utilisation de micro-vias thermiques sous les transistors du MMIC, par réduction de l'épaisseur du MMIC

Les boîtiers selon l'invention comportant un circuit intégré protégé par capot permettent outre les avantages déjà mentionnés :
- une amélioration significative du problème thermique par une réduction du chemin thermique ;
- un procédé de fabrication en traitement collectif beaucoup moins onéreux que ceux de l'état de l'art ;
- une amélioration significative des performances électriques dans les applications de logiques et analogiques rapides, grâce à des interconnexions très courtes ;
- une compatibilité avec les techniques de production de montage de composants en surface, évitant par ailleurs l'utilisation de fils de câblage ;
- l'obtention d'une cavité à air entre le capot et la face active de la puce de très faibles dimensions, ne rajoutant pas de capacités parasites, et rendant le circuit moins sensible à un enrobage ou une mise en boiter ultérieurs. En outre, les fréquences de coupure des modes supérieurs de cette cavité se trouvent bien en dehors des fréquences utilisables (dans une autre réalisation, on peut choisir la hauteur des cavités pour réaliser des guides d'ondes rectangulaires ou filtres) ;
- d'obtenir une cavité à air de très faibles dimensions, qui permet aux éléments mécaniques de composants MEMS (« micro electro-mechanical systems »en langue anglaise), de se mouvoir et donc de fonctionner ;
- la possibilité d'adapter la hauteur des cavités pour la réalisation de fenêtres optiques, de chemins de découpe, de « back-short » pour les antennes intégrées ;
- une compatibilité avec les procédés de test de production sous pointes ;
- une compatibilité avec les procédés actuels de fabrication de circuits intégrés ;
- une protection assurant un meilleur durcissement aux rayonnements.

## Revendications

1. Boîtier miniature hyperfréquences comportant une puce hyperfréquence (60) ayant une face active (62, 130, 140), comportant des conducteurs électriques (64, 132) de la face active, des composants hyperfréquences actifs (65), une face arrière (66) opposée à la face active comportant des conducteurs électriques (46, 68) de la face arrière, un capot de protection (72, 176, 178, 180),
**caractérisé en ce que** le capot (72, 176, 178, 180) de protection est fixé sur la face active (62, 130, 140) de la puce (60) la recouvrant au moins partiellement, le capot de protection ayant au moins un évidement (154) formant une cavité (80, 94, 96, 98) avec la face active de la puce.

2. Boîtier miniature hyperfréquences selon la revendication 1, **caractérisé en ce que** le capot (72) de protection recouvre la totalité de la face active (62) de la puce (60).

3. Boîtier miniature hyperfréquences selon l'une des revendications 1 à 2 **caractérisé en ce que** le capot de protection comporte plusieurs évidements, chacun des évidements, formant une cavité (80, 94, 96, 98) avec la face active de la puce.

4. Boîtier miniature hyperfréquences selon l'une des revendications 1 à 3 **caractérisé en ce que** le capot (72) de protection comporte une plaque supérieure (74) parallèle à la face active (62) de la puce, la plaque supérieure (74) étant prolongée par des parois (76) perpendiculaires à la plaque supérieure se terminant par des bords (78) en contact avec la face active (62) de la puce de façon à former avec la puce une cavité (80) comprise entre la plaque supérieure (74) du capot et la face active.

5. Boîtier miniature hyperfréquences selon la revendication 4, **caractérisé en ce que** le capot (72) de protection comporte d'autres parois (90, 92) perpendiculaires à la plaque supérieure (74) du capot de façon à former plusieurs autres cavités (94, 96, 98) avec la face active (62) de la puce.

6. Boîtier miniature hyperfréquences selon l'une des revendications 3 à 5, **caractérisé en ce que** les évidements du capot de protection formant les cavités (80, 94, 96, 98) avec la dite face active (62) de la puce (60) sont réalisés soit par gravure, soit par moulage du capot.

7. Boîtier miniature hyperfréquences selon l'une des revendications 5 ou 6 **caractérisé en ce que** le capot de protection comporte, du coté de la face (84) de la plaque (72), faisant face à la face active (62) de la puce, des conducteurs électriques et thermiques (110) du capot de protection en contact avec des conducteurs électriques de la face active (112) de la puce.

8. Boîtier miniature hyperfréquences selon l'une des revendications 4 à 7 **caractérisé en ce que** la puce (60) comporte, parmi les conducteurs électriques (132) de la face active (130) de la puce, des connexions électriques (134) pour la liaison électrique de la puce avec un circuit extérieur et **en ce que** le capot (136) de protection solidaire de la face active (130) de la puce (60) la recouvrant partiellement, laisse apparaître les connexions électriques (134) de ladite face active de la puce.

9. Boîtier miniature hyperfréquences selon l'une des revendications 1 à 8 **caractérisé en ce que** le capot de protection est réalisé de préférence dans un matériau choisi parmi, le silicium, plastique, diamant, verre, matériau organique ou polymère, métal.

10. Procédé de fabrication en collectif de boîtiers miniatures hyperfréquences selon l'une des revendications 1 à 9, **caractérisé en ce qu'**il comporte au moins les étapes suivantes :
- fabrication, sur une galette ou « wafer » en langue anglaise, soit d'Arséniure de Gallium, soit de Nitrure de Gallium, ou soit de Phosphore d'Indium, monocristallin, , d'un ensemble de circuits intégrés 139, chacun des circuits intégrés comportant une face active (140) et une face arrière (142) opposée à la face active, la face active comportant des éléments actifs (144), des conducteurs électriques (146) de la face active, la face arrière (142) comportant des conducteurs électriques (148) de la face arrière, des trous métallisés (150) dans la puce reliant les conducteurs électriques (146) de la face active aux conducteurs électriques (148) de la face arrière ;
- fabrication d'un « wafer » capot (152) à partir d'une galette de Silicium avec gravure:
a) d'évidements (154) destinés à la réalisation des cavités avec les faces actives des puces à protéger ;
b) de chemins de découpe (156) entre les capots pour la séparation des circuits intégrés capotés ;
- dépôt localisé d'un élément adhésif sur le bord (158) des évidements (154) ;
- report du « wafer » capot (152) par les bords (158) des évidements (154) sur le « wafer » circuits intégrés sur les faces actives (140) des circuits intégrés par collage ou par « wafer » bonding constituant un « wafer » circuits intégrés encapsulés (160) ;
- amincissement du « wafer circuits intégrés encapsulés (160) par le coté du « wafer » capot (152) jusqu'aux chemins de découpe (156) séparant les capots de protection des circuits intégrés du « wafer circuits intégrés ;
- découpe du « wafer » circuits intégrés encapsulés (160) pour séparer les boîtiers (170, 172, 174) comportant les circuits intégrés protégés par leurs respectifs capots (176, 178, 180).

11. Procédé d'encapsulation d'un boîtier miniature hyperfréquences selon l'une des revendications 1 à 9, **caractérisé en ce qu'**il comporte au moins les étapes suivantes :
- croissance sur un substrat temporaire (190) d'un réseau de plots électriques (192) ou « leadframe » et des plots de soudure (194) sur les plots électriques (192) ;
- report du boîtier (170) comportant un circuit intégré protégé par son capot (176) par sa face arrière (142) sur le réseau de plots électriques (192) par l'intermédiaire des plots de soudure (194) ;
- moulage (196) du circuit intégré protégé par son capot et du réseau de plots électriques (192) sur le substrat temporaire(190) ;
- amincissement du substrat temporaire (190) jusqu'aux plots électriques 192 du « leadframe » ;
- découpe et séparation d'un boîtier moulé (200) comportant le circuit intégré protégé par son capot.

## Claims

1. A microwave miniature casing including a microwave chip (60) having an active side (62, 130, 140), including electrical conductors (64, 132) on the active side, active microwave components (65), a rear side (66) opposite the active side, which includes electrical conductors (46, 68) on the rear side, and a protection cover (72, 176, 178, 180),
**characterised in that** the protection cover (72, 176, 178, 180) is mounted to the active side (62, 130, 140) of the chip (60) covering said chip at least partially, the protection cover having at least one recess (154) forming a cavity (80, 94, 96, 98) with the active side of the chip.

2. The miniature microwave casing according to claim 1, **characterised in that** the protection cover (72) covers all of the active side (62) of the chip (60).

3. The miniature microwave casing according to any one of claims 1 to 2, **characterised in that** the protection cover includes several recesses, each recess forming a cavity (80, 94, 96, 98) with the active side of the chip.

4. The miniature microwave casing according to any one of claims 1 to 3, **characterised in that** the protection cover (72) includes an upper plate (74) parallel to the active side (62) of the chip, said upper plate (74) being extended by walls (76) perpendicular to the upper plate terminated with edges (78) in contact with the active side (62) of the chip so as to form a cavity (80) with the chip, which cavity is included between the upper plate (74) of the cover and the active side.

5. The miniature microwave casing according to claim 4, **characterised in that** the protection cover (72) includes other walls (90, 92) perpendicular to the upper plate (74) of the cover so as to form several other cavities (94, 96, 98) with the active side (62) of the chip.

6. The miniature microwave casing according to any one of claims 3 to 5, **characterised in that** the recesses of the protection cover forming the cavities (80, 94, 96, 98) with said active side (62) of the chip (60) are realised either by etching or by moulding the cover.

7. The miniature microwave casing according to any one of claims 5 to 6, **characterised in that** the protection cover includes, on the side of the side (84) of the plate (72) opposite the active side (62) of the chip, electrical and thermal conductors (110) of the protection cover in contact with the electrical conductors of the active side (112) of the chip.

8. The miniature microwave casing according to any one of claims 4 to 7, **characterised in that** the chip (60) includes, among the electrical conductors (132) of the active side (130) of the chip, electrical connections (134) for electrically connecting the chip to an external circuit and **in that** the protection cover (136) integral with the active side (130) of the chip (60) partially covers said chip, revealing the electrical connections (134) of said active side of the chip.

9. The miniature microwave casing according to any one of claims 1 to 8, **characterised in that** the protection cover is preferably manufactured from a material which is selected from silicon, plastic, diamond, glass, organic material or polymer, or metal.

10. A process for manufacturing a collection of miniature microwave casings according to any one of claims 1 to 9, **characterised in that** it at least includes the following steps:
- manufacturing from a plate, or "wafer" in English, made from either gallium arsenide, or gallium nitride, or indium phosphide, or monocrystalline, a set of integrated circuits 139, each integrated circuit including an active side (140) and a rear side (142) opposite the active side, said active side including active elements (144), electrical conductors (146) on the active side, the rear side (142) including electrical conductors (148) on the rear side, metallised holes (150) in the chip connecting the electrical conductors (146) of the active side to the electrical conductors (148) of the rear side;
- manufacturing a cover "wafer" (152) from a silicon wafer, which includes etching of:
a) recesses (154) designed for creating cavities with the active sides of the chips to be protected;
b) cut-outs (156) between the covers for separating the covered integrated circuits;
- locally depositing an adhesive element on the edge (158) of the recesses (154);
- placing the cover "wafer" (152) by the edges (158) of the recesses (154) onto the integrated circuit "wafer" on the active sides (140) of the integrated circuits by adhesion or by "wafer" bonding to obtain an encapsulated integrated circuit "wafer" (160);
- thinning of the encapsulated integrated circuit "wafer" (160) by the edge of the cover "wafer" (152) up to the cut-outs (156) separating the protection covers of the integrated circuits of the "integrated circuit wafer";
- cutting out the encapsulated integrated circuit "wafer" (160) in order to separate the casings (170, 172, 174) including the integrated circuits protected by their respective covers (176, 178, 180).

11. A process for encapsulating a miniature microwave casing according to any one of claims 1 to 9, **characterised in that** it at least includes the following steps:
- growing, on a temporary substrate (190) of a network, electrical pads (192) or "leadframe" and solder pads (194) on the electrical pads (192);
- placing the casing (170) including an integrated circuit protected by its cover (176) by its rear side (142) onto the electrical pad network (192) by means of the solder pads (194);
- moulding (196) the integrated circuit protected by its cover and the network of electrical pads (192) on the temporary substrate (190);
- thinning of the temporary substrate (190) up to the electrical pads 192 of the "leadframe";
- cutting out and separating a moulded casing (200) including the integrated circuit protected by its cover.

## Patentansprüche

1. Mikrowellen-Miniaturgehäuse, das Folgendes umfasst: einen Mikrowellenchip (60), der eine aktive Seite (62, 130, 140) aufweist, mit elektrischen Leiter (64, 132) auf der aktiven Seite, aktive Mikrowellenkomponenten (65), eine Rückseite (66) gegenüber der aktiven Seite, wobei sich auf der Rückseite elektrische Leiter (46, 68) befinden, und eine Schutzabdeckung (72, 176, 178, 180),
**dadurch gekennzeichnet, dass** die Schutzabdeckung (72, 176, 178, 180) auf der aktiven Seite (62, 130, 140) des Chips (60) montiert ist und den Chip wenigstens teilweise bedeckt, wobei die Schutzabdeckung wenigstens eine Aussparung (154) aufweist, die einen Hohlraum (80, 94, 96, 98) mit der aktiven Seite des Chips bildet.

2. Mikrowellen-Miniaturgehäuse nach Anspruch 1, **dadurch gekennzeichnet, dass** die Schutzabdeckung (72) die gesamte aktive Seite (62) des Chips (60) bedeckt.

3. Mikrowellen-Miniaturgehäuse nach Anspruch 1 oder 2, **dadurch gekennzeichnet, dass** die Schutzabdeckung mehrere Aussparungen aufweist, wobei jede der Aussparungen einen Hohlraum (80, 94, 96, 98) mit der aktiven Seite des Chips bildet.

4. Mikrowellen-Miniaturgehäuse nach einem der Ansprüche 1 bis 3, **dadurch gekennzeichnet, dass** die Schutzabdeckung (72) eine obere Platte (74) parallel zur aktiven Seite (62) des Chips aufweist, wobei die obere Platte (74) durch Wände (76) lotrecht zur oberen Platte verlängert und durch Ränder (78) in Kontakt mit der aktiven Seite (62) des Chips abgeschlossen wird, um mit dem Chip einen Hohlraum (80) zu bilden, der sich zwischen der oberen Platte (74) der Abdeckung und der aktiven Seite befindet.

5. Mikrowellen-Miniaturgehäuse nach Anspruch 4, **dadurch gekennzeichnet, dass** die Schutzabdeckung (72) andere Wände (90, 92) lotrecht zur oberen Platte (74) der Abdeckung aufweist, um mehrere andere Hohlräume (94, 96, 98) mit der aktiven Seite (62) des Chips zu bilden.

6. Mikrowellen-Miniaturgehäuse nach einem der Ansprüche 3 bis 5, **dadurch gekennzeichnet, dass** die Aussparungen der Schutzabdeckung, die die Hohlräume (80, 94, 96, 98) mit der aktiven Seite (62) des Chips (60) bildet, durch Ätzen oder Formen der Abdeckung realisiert werden.

7. Mikrowellen-Miniaturgehäuse nach Anspruch 5 oder 6, **dadurch gekennzeichnet, dass** die Schutzabdeckung auf der Seite der Seite (84) der Platte (72) gegenüber der aktiven Seite (62) des Chips Strom- und Wärmeleiter (110) der Schutzabdeckung in Kontakt mit den Stromleitern der aktiven Seite (112) des Chips aufweist.

8. Mikrowellen-Miniaturgehäuse nach einem der Ansprüche 4 bis 7, **dadurch gekennzeichnet, dass** der Chip (60), unter den Stromleitern (132) der aktiven Seite (130) des Chips, elektrische Anschlüsse (134) zum elektrischen Verbinden des Chips mit einer externen Schaltung aufweist, und **dadurch**, dass die Schutzabdeckung (136) einstückig mit der aktiven Seite (130) des Chips (60) den Chip teilweise bedeckt und die elektrischen Anschlüsse (134) der aktiven Seite des Chips freilässt.

9. Mikrowellen-Miniaturgehäuse nach einem der Ansprüche 1 bis 8, **dadurch gekennzeichnet, dass** die Schutzabdeckung vorzugsweise aus einem Material hergestellt ist, das aus Silicium, Plastik, Diamant, Glas, organischem Material oder Polymer oder Metall ausgewählt ist.

10. Verfahren zur kollektiven Herstellung von Mikrowellen-Miniaturgehäusen nach einem der Ansprüche 1 bis 9, **dadurch gekennzeichnet, dass** es wenigstens die folgenden Schritte beinhaltet:
- Herstellen eines Satzes von integrierten Schaltungen 139 auf einer Platte, auf Englisch "Wafer", entweder aus Galliumarsenid oder Galliumnitrid oder Indiumphosphid, monokristallin, wobei jede integrierte Schaltung eine aktive Seite (140) und eine Rückseite (142) gegenüber der aktiven Seite aufweist, wobei die aktive Seite aktive Elemente (144), elektrische Leiter (146) auf der aktiven Seite aufweist, wobei die Rückseite (142) Stromleiter (148) auf der Rückseite aufweist, wobei metallisierte Löcher (150) in dem Chip die Stromleiter (146) der aktiven Seite mit den Stromleitern (148) der Rückseite verbinden;
- Herstellen eines Abdeck-"Wafers" (152) aus einem Siliciumwafer durch Ätzen von:
a) Aussparungen (154) zum Erzeugen von Hohlräumen mit den aktiven Seiten der zu schützenden Chips;
b) Ausschnitten (156) zwischen den Abdeckungen zum Vereinzeln der abgedeckten integrierten Schaltungen;
- lokales Absetzen eines Klebstoffelements auf dem Rand (158) der Aussparungen (154);
- Platzieren des Abdeck-"Wafers" (152) an den Rändern (158) der Aussparungen (154) auf dem integrierten Schaltungs-"Wafer" auf den aktiven Seiten (140) der integrierten Schaltungen durch Kleben oder "Wafer"-Bonden zum Erhalten eines verkapselten integrierten Schaltungs-"Wafers" (160);
- Verdünnen des verkapselten integrierten Schaltungs-"Wafers" (160) durch die Seite des Abdeck-"Wafers" (152) bis zu den Ausschnitten (156), die die Schutzabdeckungen der integrierten Schaltungen von den "integrierten Schaltungswafers" trennen;
- Ausschneiden des verkapselten integrierten Schaltungs-"Wafers" (160) zum Vereinzeln der Gehäuse (170, 172, 174), die die von den jeweiligen Abdeckungen (176, 178, 180) geschützten integrierten Schaltungen umfassen.

11. Verfahren zum Verkapseln eines Mikrowellen-Miniaturgehäuses nach einem der Ansprüche 1 bis 9, **dadurch gekennzeichnet, dass** es wenigstens die folgenden Schritte beinhaltet:
- Aufwachsenlassen, auf einem temporären Substrat (190), eines Netzwerks von Kontakthöckern (192) oder "Leadframes" und Lotperlen (194) auf den Kontakthöckern (192);
- Platzieren des Gehäuses (170), das eine durch ihre Abdeckung (176) geschützte integrierte Schaltung beinhaltet, mit ihrer Rückseite (142) auf dem Kontakthöckernetz (192) mittels der Lötstellen (194);
- Formen (196) der von ihrer Abdeckung und dem Kontakthöckernetz (192) geschützten integrierten Schaltung auf dem temporären Substrat (190);
- Verdünnen des temporären Substrats (190) bis zu den Kontakthöckern 192 des "Leadframe" ;
- Ausschneiden und Vereinzeln eines geformten Gehäuses (200), das die durch ihre Abdeckung geschützte integrierte Schaltung umfasst.
